Europäisches Patentamt

European Patent Office

Office européen des brevets

(19)

(11) Publication number: **0 116 455**

**A2**

# (12) EUROPEAN PATENT APPLICATION

(21) Application number: 84300730.3

(22) Date of filing: 06.02.84

(51) Int. Cl.³: **G 06 F 13/00**

(30) Priority: 10.02.83 US 465656

(43) Date of publication of application:
22.08.84 Bulletin 84/34

(84) Designated Contracting States:
AT BE CH DE FR GB IT LI LU NL SE

(71) Applicant: ACTIVISION, INC.
2350 Bayshore Frontage Road
Mountain View California 94043(US)

(72) Inventor: Crane, David Patrick
655 South Fairoaks Avenue
Sunnyvale California 94086(US)

(74) Representative: Horton, Andrew Robert Grant et al,
BOULT, WADE & TENNANT 27 Furnival Street
London, EC4A 1PQ(GB)

(54) Method and means for memory bank selection in a microprocessing system.

(57) Memory bank selection is provided in a pipeline architecture computer system by monitoring the address bus for an address indicative of a program instruction such as a jump to subroutine (JSR) requiring the presence of a memory address on the data bus, and then latching at least portions of the memory address when on the data bus. The latched portions of the address are decoded for memory selection, and an enable signal is then generated and applied to enable the selected memory.

FIG. — 2

EP 0 116 455 A2

-1-

"METHOD AND MEANS FOR MEMORY BANK SELECTION IN A MICROPRO-
CESSING SYSTEM "

This invention relates generally to microprocessor systems,
and more particularly the invention relates to method and
apparatus for memory bank selection in a microprocessing
system.

Microprocessors are now widely employed as control devices.
Heretofore, the controlled tasks have required relatively
simple programs and limited memory capacity.  However, as
microprocessors become more sophisticated, increased memory
capacity for control programs and data is required.  Some
microprocessors have an address bus with limited addressing
capability.  For example, a 12 line address bus can address
only $2^{12}$ or 4K memory locations.  Some microprocessors have
greater address capability, but the system is configured
to limit the address bus.  For example, the Atari VCS employs
a 6502 microcomputer which has 16 bit addressing capability.
However, the address bus to memory is limited to 12 bits with
one additional bit used to select an internal memory or an
external 4K memory.  This invention is directed to a method
and apparatus for increasing the external address capability
in such a microprocessing system.

Accordingly, an object of the present invention is a microprocessing system having increased memory capacity.

Another object of the invention is a method of selecting one of a plurality of memories each of which being addressed by one address bus.

A further object of the invention is an improved apparatus for memory bank selection in a microprocessing system.

A feature of the invention is the monitoring of the system address bus for an indication of a program instruction execution requiring the presence of a complete memory address on the data bus. The address on the data bus is then used for memory bank selection.

The invention is implemented in a microprocessing system employing "pipeline" instruction execution. In such systems, many extraneous memory fetches and memory reads are made. In executing a jump to subroutine (JSR) for example, a particular address will appear on the address bus and will be followed by a complete memory address on the data bus for loading (push) the return address stack which is then followed by the subroutine address. If a bank selection must be performed, the data bus will contain the high byte of the address. Thus, by latching the high order bits of the data bus, bank select circuitry can then select one of several memory banks.

The invention and objects and features thereof will be more readily apparent from the following detailed description and appended claims when taken with the drawing, in which:

Figure 1 is a functional block diagram of a microprocessing system.

Figure 2 is a functional block diagram of memory bank select apparatus in accordance with one embodiment of the invention.

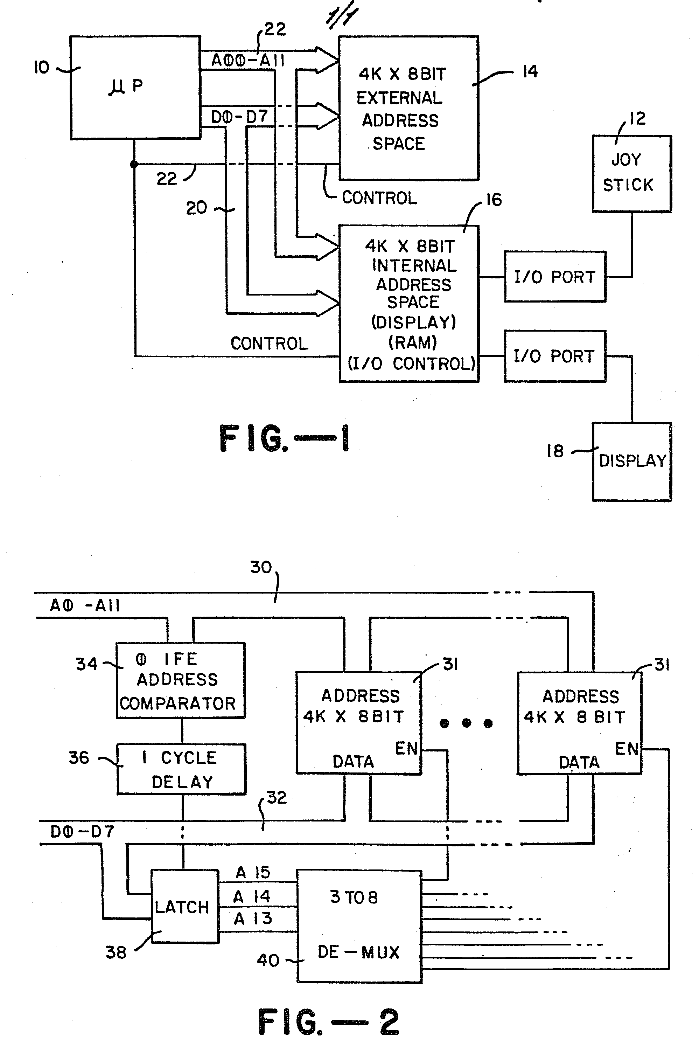

Referring now to the drawings, Figure 1 is a functional block diagram of a microprocessing system such as the Atari VCS system which utilizes a 16 bit 6502 microprocessor 10. The microprocessor responds to input signals from an input-output device 12, such as a joy stick, and under program control and data stored in an external memory 14, the microprocessor loads internal display RAM memory which controls a video display 18 connected to the system through an I/O port.

While the 6502 microprocessor has 16 bit address capability, the 13 line address bus 22 of the Atari VCS system is limited to 13 address bits (A∅∅-A12). One bit (A12) selects internal or external memory, and twelve bits (A∅∅-A11) address location in the external and internal memories. The data bus 20 has 8 data lines, D∅-D7. Since the address bus is limited to 13 bits, only $2^{13}$ or 8K memory locations can be addressed thereby. The 6502 microprocessor has the capability for addressing eight times as much memory as is permitted by the address bus 22. Further, more sophisticated applications of microprocessors demand more than 8K memory, thus, a method and apparatus is required to overcome the limited capability of the 13 line address bus.

In a microprocessor having pipeline architecture, complete addresses will appear on the data bus in response to particular program subroutines. For example, in executing a jump to a subroutine (JSR) certain addresses will appear on the data bus for storage in the return address stack (push stack execution) and the complete address of the called subroutine will then appear on the data bus. Following is a table illustrating the steps in a subroutine call in a 6502 microprocessing system (using hexidecimal arithmetic):

| Clock Cycle | Address Bus | Data Bus | Control | OP Code | Description |
|---|---|---|---|---|---|
| Ø | FØØØ | A2 | OP CODE | 1 | LDX #$FF |
| 1 | FØØ1 | FF | READ | 2 | |
| 2 | FØØ2 | 9A | OP CODE | 1 | TXS |
| 3 | FØØ3 | A9 | READ | | (False Fetch) |
| 4 | FØØ3 | A9 | OP CODE | 1 | LDA #Ø |
| 5 | FØØ4 | ØØ | READ | 2 | |
| 6 | FØØ5 | 2Ø | OP CODE | 1 | JSR $DØØØ |
| 7 | FØØ6 | ØØ | READ | 2 | |
| 8 | ØlFF | FØ | READ | | (False Load) |
| 9 | ØlFF | FØ | WRITE | | Push High Byte of Return Addr |
| 10 | ØlFE | Ø7 | WRITE | | Push Low Byte of Return Addr |
| 11 | FØØ7 | DØ | READ | 3 | (Note: High Byte of Sub-routine Addr) |
| 12 | DØØØ | A9 | OP CODE | 1 | LDA #2 |
| 13 | DØØ1 | Ø2 | READ | 2 | |
| 14 | DØØ2 | 6Ø | OP CODE | 1 | RTS |
| 15 | DØØ3 | ØØ | READ | | (False Fetch) |
| 16 | ØlFD | BØ | READ | | (False Load) |
| 17 | ØlFE | Ø7 | READ | | Pull Low Byte of Return Point |
| 18 | ØlFF | FØ | READ | | Pull High Byte of Return Point |
| 19 | FØØ7 | DØ | READ | | (Return and False Fetch) |
| 20 | FØØ8 | A9 | OP CODE | 1 | LDA #3 |
| 21 | FØØ9 | Ø3 | READ | 2 | |

For each clock cycle the above table provides the address bus content, the data bus content, and a description of the operation for each clock cycle. Initially, the address are to locations in memory bank F (i.e. FXXX). In cycle number 6, a jump to subroutine (JSR) an address 000 in memory bank D is called (DØØØ). It will be noted that JSR instruction is always followed by an address ØlFE on the address bus. One cycle thereafter the most significant 8 bits (DØ) of the new memory location appears on the data bus. Thus, by monitoring the address bus for the address Ø1FE and then latching the most significant bits on the data bus one cycle thereafter, memory bank selection can be implemented.

In the table the addresses FXXX and DXXX are in separate 4K memory banks, and at cycle number 12 the system must switch from one memory bank to the other. It will be noted that at the time the bank select must be performed the data bus contains the high byte of the address of the next instruction to be executed, and if the top three bits of the data bus are latched at this time, the bank select circuitry can allow a jump subroutine to select any of eight 4K banks of memory.

Figure 2 is a block diagram of circuitry for memory bank selection in accordance with one embodiment of the invention. The twelve line address bus 30 is connected to a plurality of 4K by eight bit memories 31. While only two banks of memory 31 are shown, in this embodiment a total of eight banks of memory can be provided. The eight line data bus 32 is connected to each of the banks of memory 31, also. An address comparator 34 is connected to the bus 30 for detecting the presence of the Ø1FE address. Actually, the comparator will detect only the lowest 12 bits or 1FE, because of the twelve bit limitation of the address bus 30. Upon detection of the Ø1FE address, a one cycle delay 36 is activated which then actuates latch 38 connected to the data bus 32. The three most significant bits on the data bus 32 are latched and provide the address bits A13, A14, and A15 which are then applied to a 3 to 8 de-multiplexer 40. The 3 bits A13-A15 define a code for selecting one of the eight banks of memory which is used to enable one of the banks of memory by applying a control signal to the enable, EN, terminal thereof. Accordingly, memory bank selection is accomplished from address codes on the data bus following a particular program instruction, such as a jump to subroutine.

0116455

By so monitoring the address bus for a specific address indicative of a routine such as JSR which loads a new memory location on the data bus, a memory code can be obtained for use in bank selection. While the invention has been described with reference to specific embodiments, the description is illustrative of the invention and is not to be construed as limiting the invention. Various modifications and applications may occur to those skilled in the art without departing from the true spirit and scope of the invention as defined by the appended claims.

CLAIMS:

1.   In a computer system with a pipeline architecture and having a processor, a bank of memories, a data bus and a memory bus interconnecting said processor and said bank of memories, said memory bus having limited address capability, a method of selecting one of said plurality of banks of memory for addressing comprising the steps of monitoring addresses on said address bus for an address indicative of a program instruction execution requiring the presence of a complete memory address on said data bus, and latching at least portions of a memory address on said data bus after detecting said address.

2.   The method as defined by Claim 1 wherein said step of monitoring addresses detects a jump to subroutine (JSR) instruction.

3.   The method as defined by Claim 2 wherein said step of latching includes latching the most significant bits of an address of the called subroutine.

4.   The method as defined by Claim 3 and further including the steps of decoding said most significant bits for selecting a bank of memory and generating an enabling signal for the selected bank of memory.

5.   The method as defined by Claim 1 and further including the steps of decoding said at least portions of a memory address for selecting a bank of memory, and generating an enabling signal for the selected bank of memory.

6.   A computer system comprising
          a processor,
          a bank of memories,

a data bus interconnecting said processor and said bank of memories,

an address bus interconnecting said processor and said bank of memories, said address bus having limited address capability,

monitoring means connected to said address bus for detecting an address indicative of a program instruction execution requiring the presence of a memory address on said data bus, and

latch means connected to said data bus for latching at least portions of an address on said data bus in response to detection of said address on said address bus.

7.   The computer system as defined by Claim 6 and further including decoder means for decoding said at least portions of said address for selection of a memory, and signal generation means operably connected to said decoder means and said bank of memories for generating an enable signal for a selected memory.

0116455

**FIG. —1**

**FIG. — 2**